(19) **Europäisches Patentamt / European Patent Office / Office européen des brevets**

(11) **EP 4 333 018 B1**

(12) **FASCICULE DE BREVET EUROPEEN**

(45) Date de publication et mention de la délivrance du brevet:
**09.04.2025 Bulletin 2025/15**

(21) Numéro de dépôt: **22306288.6**

(22) Date de dépôt: **31.08.2022**

(51) Classification Internationale des Brevets (IPC):
**H01J 37/22** *(2006.01)*

(52) Classification Coopérative des Brevets (CPC):
**H01J 37/228;** H01J 2237/24485

(54) **MÉTHODE ET SYSTÈME POUR CALIBRATION D'UN SPECTROMÈTRE POUR PARTICULES CHARGÉES**

VERFAHREN UND SYSTEM ZUR KALIBRIERUNG EINES SPEKTROMETERS FÜR GELADENE TEILCHEN

METHOD AND SYSTEM FOR CALIBRATING A CHARGED PARTICLE SPECTROMETER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**06.03.2024 Bulletin 2024/10**

(73) Titulaires:
• **Centre national de la recherche scientifique**
**75016 Paris (FR)**
• **Université Paris-Saclay**
**91190 Gif-sur-Yvette (FR)**

(72) Inventeurs:
• **GALVAO TIZEI, Luiz**
**91405 Orsay (FR)**
• **AUAD, Yves**
**91405 Orsay (FR)**
• **BLAZIT, Jean-Denis**
**91405 Orsay (FR)**
• **TENCE, Marcel**
**91405 Orsay (FR)**
• **KOCIAK, Mathieu**
**91405 Orsay (FR)**

(74) Mandataire: **IPAZ**
**Bâtiment Platon**
**Parc Les Algorithmes**
**91190 Saint-Aubin (FR)**

(56) Documents cités:
• **BRETT BARWICK ET AL: "Photon-induced near-field electron microscopy", NATURE, vol. 462, no. 7275, 1 December 2009 (2009-12-01), London, pages 902 - 906, XP055648912, ISSN: 0028-0836, DOI: 10.1038/nature08662**
• **GARCÍA DE ABAJO F. JAVIER ET AL: "Multiphoton Absorption and Emission by Interaction of Swift Electrons with Evanescent Light Fields", NANO LETTERS, vol. 10, no. 5, 12 May 2010 (2010-05-12), US, pages 1859 - 1863, XP093029946, ISSN: 1530-6984, DOI: 10.1021/nl100613s**
• **SAPOZHNIK ALEXEY ET AL: "Integrated Nanophotonic Electron Beam Modulators Enable Ultra-High Precise Method for Calibrating EELS Spectrometers", MICROSCOPY AND MICROANALYSIS, vol. 28, no. S1, 1 August 2022 (2022-08-01), pages 792 - 793, XP093000506, ISSN: 1431-9276, Retrieved from the Internet <URL:https://www.cambridge.org/core/services/aop-cambridge-core/content/view/2B7BB908F6294106EE45D2BA005AC17C/S1431927622003579a.pdf/integrated-nanophotonic-electron-beam-modulators-enable-ultra-high-precise-method-for-calibrating-eels-spectrometers.pdf> DOI: 10.1017/S1431927622003579**

EP 4 333 018 B1

**EP 4 333 018 B1**

**Description**

<u>Domaine technique</u> :

La présente invention concerne le domaine des spectromètres pour particules chargées et plus particulièrement la calibration des spectromètres pour particules chargées. Par « spectromètres pour particules chargées », on entend ici des spectromètres adaptés pour mesurer le spectre d'énergie de molécules chargées ou d'électrons ou encore d'ions.

<u>Technique antérieure</u> :

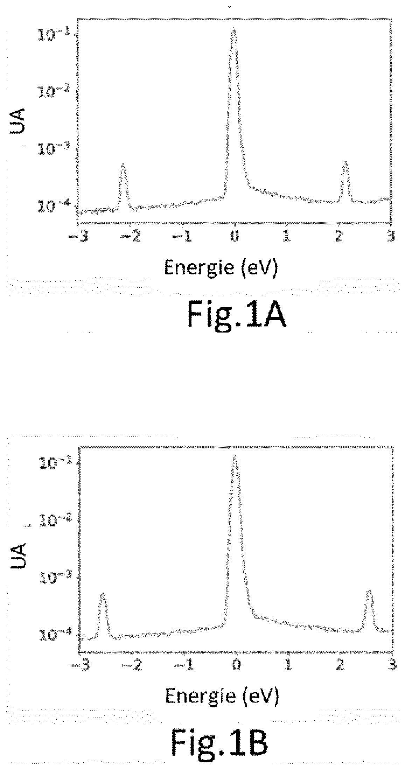

La figure 1A illustre un spectre typique de perte d'énergie d'un électron (ou EELS pour l'acronyme anglais de *Electron Energy Loss Spectra*) dans le cas où une interaction se produit entre l'électron et de la lumière. Le pic central, à énergie nulle, est appelé pic de perte nulle (ou ZLP pour l'acronyme anglais de *Zero Loss Peak*). Des deux côtés, on peut voir deux pics, qui sont respectivement le pic EELS stimulé du premier ordre (à droite) et le pic de gain d'énergie d'électron stimulé noté EEGS (à gauche).

De manière connue en soi, les mesures effectuées par les spectromètres pour particules chargées et plus particulièrement les spectromètres d'électrons souffrent de plusieurs types d'erreurs de calibration.

La figure 1B illustre l'effet d'une erreur de calibation linéaire d'un spectromètre sur la mesure du spectre d'énergie de l'électron avec le spectre de la figure 1A. A titre d'exemple, on observe sur la figure 1B que les pics sont décalés symétriquement par rapport à 0 vers des énergies plus importantes en valeur absolue que celles observées dans la figure 1A. Plus généralement, l'effet d'une erreur d'échelle.

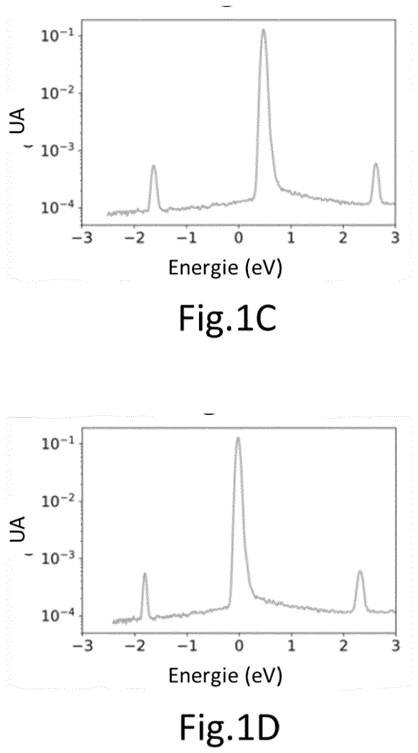

La figure 1C illustre l'effet d'une erreur de type décalage d'un spectromètre sur la mesure du spectre d'énergie de l'électron avec le spectre de la figure 1A. Ici, on observe que les pics sont décalés non symétriquement d'une même valeur *O* vers des énergies plus importantes que celles observées dans la figure 1A. Plus généralement, l'effet d'une erreur de type décalage est une addition d'une valeur égale au décalage *O* à la valeur de l'énergie des pics EEGS et EELS, cette valeur *O* pouvant être négative.

La figure 1D illustre l'effet d'une erreur non-linéaire d'un spectromètre sur la mesure du spectre d'énergie de l'électron avec le spectre de la figure 1A. On observe que les pics sont décalés non-symétriquement par rapport à 0 et de manière différente entre le pic EEGS et EELS par rapport à la figure 1A.

Dans les meilleurs spectromètres d'électrons, généralement utilisé dans les microscopes électroniques pour la spectroscopie EELS, la précision linéaire et l'exactitude sont limitées à environ 1 % (10 eV à 1000 eV ou 20 meV à 2 eV). Par « précision linéaire et exactitude » on entend ici la précision dans la détermination de S et de O respectivement. En effet, il existe typiquement deux façons connues de calibrer le facteur d'échelle S et le décalage O des spectres de particules chargées.

Une première méthode consiste à utiliser un étalon traversé par le faisceau de particules chargées et présentant une caractéristique spectrale (absorption, gain) d'énergie connue. Cette caractéristique spectrale peut être déterminée par des calculs ou des expériences préalables. Il est alors possible de déterminer le facteur d'échelle S et le décalage O par une mesure du spectre des particules chargées sans traversée de l'étalon et par une mesure du spectre des particules chargées avec traversée de l'étalon. Cependant, cette méthode présente un inconvénient important. En effet, les incertitudes liées à l'énergie de transition dans les solides entrainent une incertitude dans la détermination du facteur d'échelle S et du décalage O. Par exemple, le seuil L d'absorption du Ni dans le NiO peut être déterminé avec une précision de 0.1 eV mais avec une exactitude faible car la position en énergie du seuil L précise dépend de l'état d'oxydation réel de Ni.

Une deuxième méthode consiste à modifier l'énergie de la particule du faisceau émis d'une quantité supposée connue, typiquement par l'application d'un champ magnétique ou d'un potentiel électrique. Il est alors possible de déterminer le facteur d'échelle S et le décalage O par deux mesures du spectre des particules chargées avec deux énergies différentes.

Cependant, à l'heure actuelle, les deux méthodes souffrent des incertitudes dues aux déviations de la trajectoire des électrons du fait de divers effets (champs de fuite dans les éléments optiques des particules chargées, aberrations...). Ces effets entrainent une incertitude dans la détermination du facteur d'échelle S et du décalage O.

L'invention vise à pallier certains problèmes de l'art antérieur. A cet effet, un objet de l'invention est une méthode (et un système associé) pour calibration d'un spectromètre pour particules chargées comprenant une étape consistant à effectuer un couplage, *via* un champ électromagnétique évanescent, entre un faisceau laser et un faisceau de particules chargées. Ce couplage permet de générer un faisceau de particules chargées présentant un spectre comprenant une pluralité de pics d'énergies distincts séparés spectralement d'une énergie égale à l'énergie du faisceau laser. A l'aide du spectromètre pour particules chargées, on détermine une variation d'énergie d'au moins deux des pics d'énergies distincts par rapport à l'énergie du faisceau de particules chargées. A partir des variations d'énergie, il est alors possible de déterminer une valeur du facteur d'échelle *S* et une valeur du décalage *O* propre à la mesure du spectre du faisceau de

2

sortie par le spectromètre. Une méthode de calibration par interaction avec un champ optique est connue de Sapozhnik et al "Integrated Nanophotonic Electron Beam Modulators Enable Ultra-High Precise Method for Calibrating EELS Spectrometers", microscopy and microanalysis, 28, 792-793 (2022), DOI: 10.1017/S1431927622003579.

La méthode de l'invention présente l'avantage de permettre une détermination du facteur d'échelle $S$ et du décalage $O$ avec une précision limitée uniquement par la précision de l'énergie du faisceau laser. Elle permet une amélioration de plusieurs ordres de grandeur dans la mesure du facteur d'échelle $S$ et du décalage $O$ par rapport aux méthodes connues de l'art.

**<u>Résumé de l'invention :</u>**

A cet effet, un objet de l'invention est une méthode de calibration d'un spectromètre pour particules chargées comprenant les étapes suivantes :

A. générer un faisceau de particules chargées incident monochromatique présentant une première énergie $E_1$;
B. générer un faisceau laser incident présentant une deuxième énergie $E_2$ ;
C. illuminer une surface d'un échantillon avec le faisceau laser incident afin de générer un champ électromagnétique évanescent dans une région à proximité de ladite surface ;
D. superposer spatialement et temporellement le faisceau laser incident et le faisceau de particules chargées incident dans ladite région afin de les coupler via ledit champ électromagnétique évanescent en générant un faisceau de particules chargées dit faisceau de sortie présentant un spectre comprenant une pluralité de pics d'énergies distincts séparés spectralement d'une valeur égale à la deuxième énergie $E_2$;
E. mesurer, par le spectromètre, tout ou partie du spectre du faisceau de sortie, puis déterminer une variation d'énergie $\Delta E$ d'au moins deux des pics d'énergies distincts par rapport à la première énergie $E_1$ ;
F. déterminer une valeur du facteur d'échelle $S$ et une valeur du décalage $O$ propre à ladite mesure du spectre du faisceau de sortie par le spectromètre à partir des variations d'énergie $\Delta E$.

De manière préférentielle, la variation d'énergie $\Delta E$ de chacun des au moins deux pics d'énergie distincts est égale à $\Delta E = \pm p \times E_2$, avec $p$ un nombre entier positif ou nul égal à un nombre d'intervalles inter-pics séparant ledit pic d'énergie distinct du pic du spectre à la première énergie $E_1$ et dans laquelle ladite variation d'énergie $\Delta E$ de chacun des au moins deux pics d'énergies distincts est déterminée dans l'étape E par le spectromètre par la relation suivante, nommée première équation :

$$\Delta E(c) = c \times S + O + NL(c)$$

avec c un canal d'un détecteur matriciel du spectromètre où est détecté ledit pic d'énergie distinct, avec $NL(c)$ une fonction du canal c représentative de non-linéarités subies par les particules chargées lors de leur trajet et détection, dite fonction NL.

Selon un premier mode de réalisation, on détermine que lesdites non-linéarités subies par les particules chargées sont faibles ou nulles, et, dans l'étape E, on détermine la variation d'énergie $\Delta E$ de deux des pics d'énergies distincts, numérotés par l'indice 1 et 2 respectivement via la première l'équation de manière à obtenir le premier système (S1) suivant :

$$(S1)\begin{cases} \Delta E(c_1) = c_1 \times S + O = \pm n_1 \times E_2 \\ \Delta E(c_2) = c_2 \times S + O = \pm n_2 \times E_2 \end{cases}$$

l'étape F consistant à résoudre le premier système d'équation (S1) pour déterminer la valeur du facteur d'échelle S et la valeur du décalage.

De manière préférentielle, dans le premier mode de réalisation, un nombre m > 1 entier d'intervalles inter-pics séparant lesdits deux pics pour lesquels est déterminée la variation d'énergie $\Delta E$ est telle qu'une erreur sur la détermination de la valeur facteur d'échelle est inférieure ou égale à 1% de la deuxième énergie.

Selon un second mode de réalisation, on détermine que les non-linéarités subies par lesdites particules chargées ne sont pas faibles ou nulles et, dans l'étape E, on détermine la variation d'énergie $\Delta E$ d'un nombre $N > 2$ pics d'énergies distincts chacun numéroté par un indice $i \in [1; N]$ via la première l'équation de manière à obtenir le deuxième système (S2) suivant :

$$(S2)\, i \in [1; N]\{\Delta E(c_i) = c_i \times S + O + NL(c_i) = \pm n_i \times E_2$$

l'étape F consistant à :

- résoudre le deuxième système d'équation (S2) pour déterminer la valeur du facteur d'échelle $S$ et la valeur du décalage $O$ et les N valeurs $NL(c_i)$, $i \in [1; N]$ de la fonction NL ;

- extrapoler la fonction NL à partir des N valeurs $NL(c_i)$, $i \in [1; N]$ afin de caractériser les non-linéarités subies par les particules chargées lors de leur trajet et détection.

De manière préférentielle, la méthode du second mode de réalisation comprend une étape ultérieure à l'étape F consistant à minimiser de manière itérative les valeurs de la fonction NL en répétant les étapes A à F une pluralité de fois et en modifiant des paramètres du trajet et de la détection des particules chargées entre chaque itération.

Selon un mode de réalisation, l'étape D comprend en outre une sous étape consistant à mesurer un spectre du faisceau laser incident simultanément à la génération du faisceau de sortie, la détermination la valeur du facteur d'échelle $S$ et la valeur du décalage $O$ étant effectuée à partir de ladite mesure du spectre du faisceau laser incident.

Un autre objet de l'invention est un système pour calibrer un spectromètre pour particules chargées, ledit système comprenant :

- une source de particules chargées adaptée pour générer un faisceau de particules chargées incident monochromatique présentant une première énergie $E_1$ ;

- une source laser adaptée pour générer un faisceau laser incident présentant une deuxième énergie $E_2$ ;

- un ensemble de transport optique et de particules chargées adapté pour :

  • illuminer une surface d'un échantillon avec le faisceau laser incident afin de générer un champ électromagnétique évanescent dans une région à proximité de ladite surface ;

  • superposer spatialement et temporellement le faisceau laser incident et le faisceau de particules chargées incident dans ladite région afin de les coupler via ledit champ électromagnétique évanescent de manière à générer un faisceau de particules chargées dit faisceau de sortie présentant un spectre comprenant une pluralité de pics d'énergies distincts séparés spectralement d'une valeur égale à la deuxième énergie $E_2$;

ledit spectromètre étant adapté pour mesurer tout ou partie du spectre du faisceau de sortie, ledit système comprenant en outre un processeur relié au spectromètre et adapté pour :

  • déterminer une variation d'énergie $\Delta E$ d'au moins deux des pics d'énergies distincts par rapport à la première énergie $E_1$ ;

  • déterminer une valeur du facteur d'échelle $S$ et une valeur du décalage $O$ propre à ladite mesure du spectre du faisceau de sortie par le spectromètre à partir des variations d'énergie $\Delta E$.

De manière préférentielle, le faisceau laser incident est un faisceau continu ou un faisceau impulsionnel avec une largeur spectrale inférieure à 40 meV.

Selon un mode de réalisation, le système comprend un spectromètre additionnel optique adapté pour mesurer un spectre du faisceau laser incident simultanément à la génération du faisceau de sortie, le processeur étant également relié au spectromètre additionnel de sorte que la détermination la valeur du facteur d'échelle $S$ et la valeur du décalage $O$ soit effectuée à partir de ladite mesure du spectre du faisceau laser incident.

De manière préférentielle, la source laser et l'ensemble de transport sont adaptés pour que le faisceau laser incident présente intensité supérieure ou égale à $10^8$ $W/cm^2$ dans ladite région.

De manière préférentielle, la source laser et l'ensemble de transport sont adaptés pour que le faisceau laser incident présente une polarisation selon une direction adaptée à la géométrie et la symétrie de l'échantillon afin de maximiser localement l'intensité du champ évanescent dans ladite région.

De manière préférentielle, ledit ensemble de transport comprend une parabole hors axe adaptée pour focaliser le faisceau laser incident sur ladite surface de l'échantillon, ladite parabole présentant une ouverture traversée par le faisceau de particules chargées incident de sorte qu'il se co-propage avec le faisceau laser incident vers ladite région après que ce dernier se soit réfléchi sur ladite parabole hors axe.

De manière préférentielle, le système comprend une cavité optique résonante pour le faisceau laser incident dans laquelle est agencé l'échantillon, ledit ensemble de transport et ladite cavité optique étant en outre adaptés pour que le faisceau laser incident effectue une pluralité de réflexions dans la cavité optique en traversant ladite région.

## Brève description des figures :

D'autres caractéristiques, détails et avantages de l'invention ressortiront à la lecture de la description faite en référence aux dessins annexés donnés à titre d'exemple et qui représentent, respectivement :

[Fig.1A], un spectre typique de perte d'énergie d'un électron (EELS) dans le cas où une interaction se produit entre l'électron et de la lumière
[Fig.1B], [Fig.1C], [Fig.1D], l'effet d'une erreur d'échelle, d'une erreur de type décalage et d'une erreur non linéaire respectivement sur la mesure du spectre d'énergie de l'électron avec le spectre de la figure 1A,
[Fig.2], une représentation graphique de la méthode selon l'invention pour la calibration d'un spectromètre pour particules chargées,
[Fig.3], une représentation schématique du système selon l'invention pour calibrer un spectromètre pour particules chargées,
[Fig.4A], une représentation graphique de l'intensité du champ évanescent généré dans la région,
[Fig.4B], un diagramme d'énergie représentant l'interaction particules chargées-photons de l'étape D de la méthode de l'invention,
[Fig.4C], un exemple de spectre de perte d'énergie comprenant trois pics EELS et trois pics EEGS et le pic ZLP,
[Fig.5], une représentation schématique d'un mode de réalisation particulier de l'invention dans lequel le système de l'invention comprend un spectromètre optique additionnel adapté pour mesurer un spectre du faisceau laser incident simultanément à la génération du faisceau de sortie,
[Fig.6], une représentation schématique d'un mode de réalisation particulier de l'invention, dans lequel le système de l'invention comprend une cavité optique dans laquelle est agencé l'échantillon,
[Fig.7], une représentation graphique de la méthode selon le second mode de réalisation de l'invention,

Dans les figures, sauf contre-indication, les éléments ne sont pas à l'échelle.

## Description détaillée :

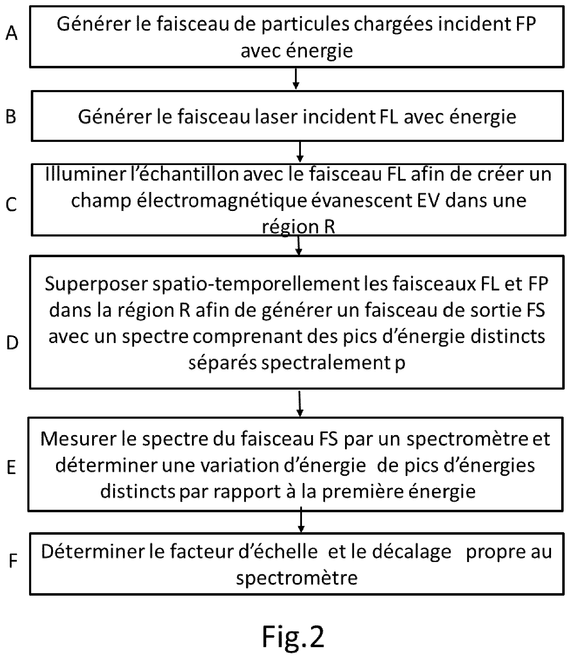

La figure 2 est une représentation graphique de la méthode selon l'invention pour la calibration d'un spectromètre SM pour particules chargées. Comme évoquée plus haut, la méthode de l'invention méthode vise à calculer le facteur d'échelle S et le décalage $O$ associé aux mesures du spectromètre SM.

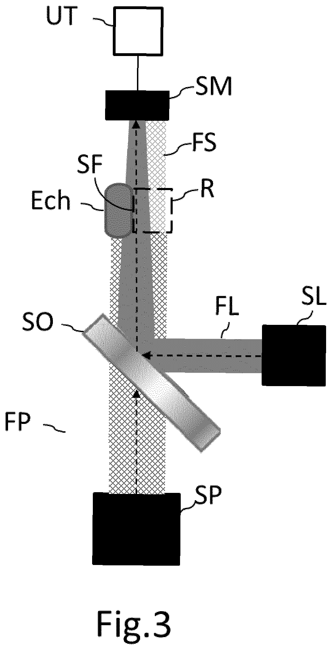

La figure 3 illustre schématiquement le système 1 selon l'invention pour calibrer un spectromètre SM pour particules chargées. Le système 1 est spécifiquement adapté pour mettre en œuvre la méthode de l'invention illustrée en figure 2. Le système 1 comprend notamment une source SP de particules chargées, une source laser SL, un ensemble de transport SO optique et de particules chargées, un échantillon Ech et le spectromètre SM.

Dans une étape A de la méthode de l'invention, la source SP de particules chargées génère un faisceau de particules chargées incident FP. La source SP est adaptée pour que le faisceau FP soit monochromatique de manière à présenter une première énergie $E_1$. Par « monochromatique », on entend ici que le faisceau FP présente la première énergie $E_1$ à $< \pm 0.1\%$.

Dans une étape B, la source laser SL génère un faisceau laser incident FL présentant une deuxième énergie $E_2 = \hbar\omega_2$, avec $\omega_2$ une fréquence centrale du faisceau laser incident. Selon un mode de réalisation, la source laser SL délivre un faisceau impulsionnel. Alternativement, selon un autre mode de réalisation, la source laser SL délivre un faisceau continu. Comme cela sera détaillé plus loin, la durée des impulsions -via la largeur spectrale- influe directement sur la précision de la détermination du facteur d'échelle S et du décalage O.

Les sources SL et SP sont configurées pour que les faisceaux FL et FP soient dirigés vers l'ensemble de transport SO.

Dans une étape C, l'ensemble de transport SO dirige le faisceau laser incident FL de sorte qu'il illumine une surface SF de l'échantillon Ech de manière à générer un champ électromagnétique évanescent EV dans une région R à proximité de la surface SF.

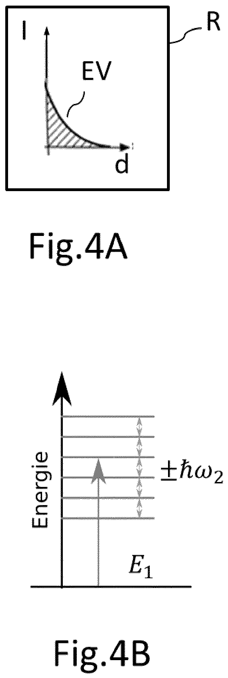

A titre purement illustratif, la figure 4A est une représentation graphique de l'intensité du champ évanescent EV dans la région R en fonction de la distance d par rapport à la surface SF.

L'échantillon de l'invention peut prendre toute forme connue de l'homme de l'art permettant la génération du champ évanescent EV par une illumination laser. A titre d'exemple non limitatif, l'échantillon est une surface métallique, un nanotube métallique, un nanofil métallique, une nanosphère, une fibre optique, une cavité fibrée en anneau, un guide d'onde ou plus généralement une cavité optique.

Dans une étape D, l'ensemble de transport SO superpose spatialement et temporellement le faisceau laser incident FL et le faisceau de particules chargées incident FP dans la région R. Par cette superposition, un couplage entre les faisceaux FL et FP est permis via le champ évanescent EV. Ce couplage consiste en l'absorption ou l'émission, par les particules chargées, de photons du faisceau laser FL et permet la génération d'un faisceau de particules chargées (nommé faisceau de sortie FS) présentant un spectre comprenant une pluralité de pics d'énergies distincts séparés spectralement d'une valeur égale à la deuxième énergie $E_2$.

Ce mécanisme de couplage est connu de l'homme de l'art et est décrit pour l'interaction photon/électron dans le document Barwick, B., Flannigan, D. J., & Zewail, A. H. (2009). Photon-induced near-field electron microscopy. Nature, 462(7275), 902-906. Ce phénomène est un mécanisme non-linéaire dans lequel une particule chargée du faisceau FP d'énergie initiale $E_1$ absorbe ou émet $n \geq 1$ photons de manière à gagner ou perdre une énergie égale à un multiple de l'énergie $E_2$ d'un photon du faisceau laser FL. Après cette interaction, l'énergie de la particule chargée est donc $E_1' = E_1 \pm n \times E_2$, avec $E_1'$ l'énergie de la particule chargée dans le faisceau de sortie FS. La figure 4B est le diagramme d'énergie représentant cette interaction.

A la suite de cette interaction photon/particules chargées, le faisceau de sortie FS présente donc un spectre d'énergie comprenant une pluralité de pics d'énergie distincts à des énergies $E_1' = E_1 \pm n \times E_2$ ($n \geq 1$) et à une énergie $E_1$ (le pic nommé ZLP). Pour la suite, afin de faciliter les notations, on dira par la suite que le faisceau de sortie FS présente un spectre d'énergie comprenant une pluralité de pics d'énergie distincts à des énergies $E_1' = E_1 \pm p \times E_2$ ($p$ entier supérieur ou égal à 0).

Dans une étape E, le faisceau de sortie est dirigé dans le spectromètre SM qui mesure tout ou partie du spectre du faisceau de sortie FS. Plus précisément, le spectromètre mesure un spectre de perte d'énergie du faisceau de sortie FS. Dans l'invention, il est essentiel que la partie mesurée du spectre du faisceau de sortie FS comprennent au moins deux des pics d'énergies distincts afin de pouvoir déterminer le facteur d'échelle $S$ et le décalage $O$ (voir plus loin).

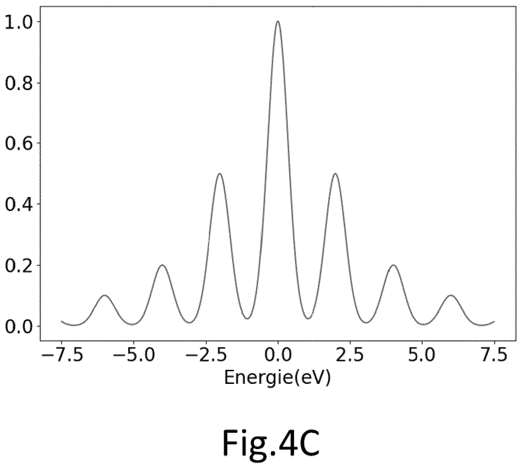

La figure 4C illustre un exemple de spectre de perte d'énergie obtenu dans l'étape E comprenant trois pics EELS et trois pics EEGS et le pic ZLP à une variation d'énergie nulle (c'est-à-dire du pic correspondant aux particules chargées d'énergie $E_1$). A titre d'exemple non limitatif, dans l'exemple de la figure 4C, la source laser SL émet un faisceau FL présentant une longueur d'onde de 519 nm, soit 2.4 eV. Aussi, les pics du spectre de la figure 4C sont séparés de 2.4 eV.

On note que le nombre $p$ de photons absorbés/émis par la particule chargée d'énergie $E_1' = E_1 \pm p \times E_2$ est égal au nombre d'intervalles inter-pics séparant le pic d'énergie distinct du pic ZLP.

Le système comprend en outre un processeur UT relié au spectromètre SM et adapté pour déterminer une variation d'énergie $\Delta E$ d'au moins deux des pics d'énergies distincts par rapport à la première énergie $E_1$. C'est-à-dire que le processeur sélectionne au moins deux pics du spectre mesuré, chacun à une énergie $E_1' = E_1 \pm p \times E_2$ puis calcule $\Delta E = E_1' - E_1 = \pm p \times E_2$. Les pics sélectionnés pour le calcul de la variation d'énergie $\Delta E$ ne sont pas nécessairement différents du pic du spectre à l'énergie $E_1$. Le processeur peut donc sélectionner le pic ZLP et un pic à une énergie $E_1' = E_1 \pm n \times E_2$ ($n \geq 1$).

On note $m$ le nombre d'intervalles inter-pics séparant les deux pics sélectionnés et on note $E_m$ l'énergie les séparant.

Dans une étape finale F, le processeur détermine la valeur du facteur d'échelle $S$ et la valeur du décalage $O$ propre au spectromètre SM à partir de ces variations d'énergie $\Delta E$. En effet, de manière connue en soi, les variations d'énergie $\Delta E$ sont déterminées dans l'étape E par le spectromètre et le processeur via la relation suivante, nommée première équation :

$$\Delta E(c) = c \times S + O + NL(c)$$

avec $c$ un canal d'un détecteur matriciel du spectromètre où est détecté le pic d'énergie distinct, et avec $NL(c)$ une fonction du canal c représentative de non-linéarités subies par les particules chargées lors de leur trajet et détection, dite fonction NL. Ces non linéarités sont typiquement dues aux composants optiques du système 1 et au détecteur matriciel du spectromètre.

Par « canal du détecteur matriciel du spectromètre », on entend ici la rangée, ou sous-partie de la rangée (ou colonne ou sous-partie de la colonne selon l'orientation du détecteur) de pixel où est détecté le pic d'énergie distinct.

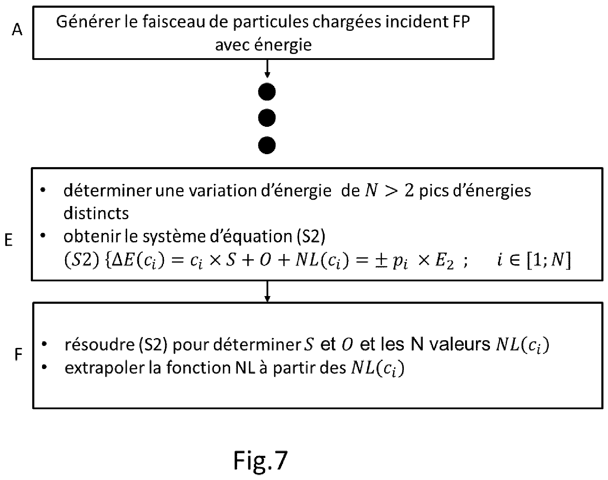

L'invention comprend deux modes de réalisation distincts, un premier mode de réalisation dans lequel on détermine uniquement la valeur du facteur d'échelle $S$ et la valeur du décalage $O$ (erreur linéaire) et un second mode de réalisation dans lequel on détermine la valeur du facteur d'échelle $S$ et la valeur du décalage $O$ et on extrapole la fonction NL (l'erreur non-linéaire), voir figure 7 et description associé plus loin).

Selon le premier mode de réalisation de l'invention, le processeur détermine que les non linéarités subies par les particules chargées lors de leur trajet et détection sont faibles ou nulles. Par exemple, le processeur détermine que les

valeurs $c \times S + O$ sont très supérieures aux valeurs $NL(c)$. Par « très supérieures », on entend ici que les valeurs $c \times S + O$ sont supérieures à dix fois les valeurs valeurs $NL(c)$.. Dans le premier mode de réalisation, l'étape E consiste alors à déterminer la variation d'énergie $\Delta E$ de deux des pics d'énergies distincts, numérotés par l'indice 1 et 2 respectivement, via la première l'équation de manière à obtenir le premier système (S1) suivant :

$$(S1) \begin{cases} \Delta E(c_1) = c_1 \times S + O = \pm p_1 \times E_2 \\ \Delta E(c_2) = c_2 \times S + O = \pm p_2 \times E_2 \end{cases}$$

avec $c_1$ et $c_2$ les canaux du détecteur matriciel où sont détectés les pics d'énergie distinct d'indice 1 et 2 respectivement et avec $p_1$ et $p_2$ le nombre de photons absorbés/émis par les particules chargées des pics d'indice 1 et 2 respectivement.

On possède alors un premier système (S1) de deux équations à deux inconnues. L'étape F du premier mode de réalisation consiste alors à résoudre le premier système d'équation (S1) pour déterminer la valeur du facteur d'échelle $S$ et la valeur du décalage $O$.

Considérons deux des pics d'énergie distincts séparés par un nombre d'intervalles inter-pics égal à m et séparés d'une énergie $E_m$. Soit $d$ un nombre de canaux séparant deux pics d'énergie distincts adjacents sur le détecteur matriciel du spectromètre. Par « pics d'énergie distincts adjacents », on entend ici des pics d'énergie séparés d'une énergie égale à $E_2$. Les deux pics sélectionnés sont séparés d'un nombre de canaux $m \times$ d sur le détecteur matriciel.

On a alors :

$$S = \frac{E_m}{m \times d} = \frac{m \times E_2}{m \times d} = \frac{E_2}{d}.$$

Soit, $\Delta E_m$ la précision sur la valeur de l'énergie $E_m$ séparant les deux pics d'énergie distincts et soit $\Delta d_m$ la précision sur la détermination du nombre de canaux séparant les deux pics d'énergie distincts sur le détecteur matriciel. On considère que la précision $\Delta E_m$ est égale à la précision sur la valeur de l'énergie des photons du faisceau laser FL émis par la source SL. Cette précision est la largeur spectrale $LS$ du faisceau laser FL

De plus, on considère que précision $\Delta d_m$ est égale au pas du pixel du détecteur $\Delta d$.

La précision sur la détermination de $S$ vaut alors :

$$\Delta S = \sqrt{\left(\frac{\delta S}{\delta E_2}\right)^2 LS^2 + \left(\frac{\delta S}{\delta d}\right)^2 \Delta d^2} = \sqrt{\frac{1}{d^2} LS^2 + \frac{E_2^2}{d^4} \Delta d^2}$$

**En** définissant $\Delta S_m = \Delta S/m$, on a :

$$\Delta S_m = \frac{1}{m} \sqrt{\frac{1}{d^2} \Delta E_m{}^2 + \frac{E_2^2}{d^4} \Delta d_m{}^2}$$

On observe que la valeur de la précision sur la détermination de $S$ est inversement proportionnelle avec le nombre d'intervalles inter-pics m et est égale à $\Delta S_m = \Delta S/m$ car $\Delta E_m = LS$ et car $\Delta d_m = \Delta d$.

De ces calculs, on détermine deux conclusions importantes :

A. la méthode de l'invention selon le premier mode de réalisation de l'invention permet une détermination de la valeur du facteur d'échelle $S$ et la valeur du décalage $O$ avec une erreur limitée par la largeur spectrale $LS$ du faisceau laser,

B. afin d'améliorer la précision sur la détermination de $S$, il faut mesurer des pics avec un nombre d'intervalles inter-pics m plus élevé.

La méthode de calibration de l'invention permet de déterminer une valeur du facteur d'échelle $S$ avec une précision $\Delta S$ de l'ordre de 0,01% ou moins de l'énergie $E_2$ du faisceau laser FL, et cela même en mesurant la variation d'énergie $\Delta E$ avec deux pics d'énergie distincts présentant un nombre intervalles inter-pics m égal à 1. Par exemple, avec des lasers commerciaux et des spectromètres optiques, une précision $\Delta S$ de 30 $\mu$eV pour une énergie $E_2 = 2eV$ (soit 620 nm de longueur d'onde) est réalisable en utilisant une source laser SL avec une largeur spectrale de 10 pm. Une précision $\Delta S$ améliorée peut être obtenue en utilisant un laser avec une meilleure résolution spectrale. À l'heure actuelle, même une précision de 0.001% de l'énergie $E_2$ pour le facteur d'échelle $S$ et pour le décalage $O$ est déjà supérieure de deux ordres de grandeur à la résolution spectrale des spectromètres électroniques de pointe.

Selon un mode de réalisation préféré de l'invention, le faisceau laser incident est un faisceau continu ou un faisceau impulsionnel avec une largeur spectrale inférieure à 40 meV. Ainsi, en adaptant la détection du spectromètre SM, il est possible d'assurer une détermination de la valeur du facteur d'échelle S avec une précision $\Delta S$ inférieure ou égale à 0,01% de l'énergie $E_2$.

Selon un mode de réalisation, la source laser SL est un laser femtoseconde présentant une largeur spectrale $LS$ = 40 meV et le détecteur matriciel du spectromètre SM avec 1000 canaux et une dispersion de 20 meV/canal. En effectuant une mesure de la variation d'énergie $\Delta E$ avec deux pics d'énergie distincts présentant un nombre intervalles inter-pics m égale à 5, on effectue une détermination de la valeur du facteur d'échelle $S$ avec une précision $\Delta S = \frac{20}{m.d} =$ 0.004meV, soit une précision $\Delta S$ égale à 0,01% de l'énergie $E_2$.

De manière plus générale, selon un mode de réalisation préféré de l'invention, pour une largeur spectrale $LS$ fixée, le spectromètre SM est adapté pour que le nombre intervalles inter-pics $m$ séparant les deux pics pour lesquels est déterminée la variation d'énergie $\Delta E$ est tel que $\Delta S$ soit inférieur ou égal à 1% de la deuxième énergie $E_2$, préférentiellement inférieure à 0.01% de la deuxième énergie $E_2$.

Il a été démontré que la probabilité que l'interaction photon/particule chargée donnant lieu aux pics d'énergies distincts ait lieu est proportionnelle à l'intensité du champ évanescent EV (F. Javier Garcia de Abajo et al., Nano Letters, 10, 1859 (2010)). De plus, de manière connue, la sensibilité de détection du spectromètre SM est limitée par le bruit de fond provenant de nombreux facteurs. Aussi, selon un mode de réalisation préféré de l'invention, la source laser SL et l'ensemble de transport SO sont adaptés pour que le faisceau laser incident présente une intensité supérieure ou égale à $10^8$ $W/cm^2$ dans la région R. Cette intensité permet de générer un champ évanescent EV avec une intensité suffisamment importante pour que le taux de l'interaction photon/particule chargée soit suffisamment élevé pour générer une pluralité de pics d'énergies dans le faisceau de sortie FS suffisamment intenses pour permettre leur détection par le spectromètre SM. L'augmentation de l'intensité faisceau laser incident dans la région R permettra donc une détection d'un nombre de pics distincts plus important dans le spectre du faisceau de sortie, ce qui permettra d'améliorer la précision dans la détermination du facteur d'échelle S et du décalage 0 par la sélection d'un nombre intervalles inter-pics m plus important dans l'étape E.

Dans le mode de réalisation illustré dans la figure 3, l'ensemble de transport SO comprend une parabole hors d'axe permettant de focaliser le faisceau laser incident FL dans la région R. La parabole présente une ouverture traversée par le faisceau de particules chargées incident de sorte qu'il se co-propage avec le faisceau laser incident vers la région après que ce dernier se soit réfléchi sur la parabole hors axe. Ce mode de réalisation présente l'avantage d'être simple à mettre en œuvre.

Bien que ce montage soit préféré, il est entendu que d'autres dispositifs de transport des faisceaux FL et FP peuvent être utilisés par l'homme de l'art afin de former l'ensemble de transport SO. Aussi, selon un autre mode de réalisation, l'ensemble de transport SO comprend un ou plusieurs miroirs et/ou une ou plusieurs lentilles et/ou un couplage fibré.

Afin de contrôler plus facilement la superposition temporelle des faisceaux FL et FP, selon un mode de réalisation de l'invention, le système 1 comprend une ligne à retard disposée sur le trajet optique du faisceau laser FL.

De manière préférentielle, la source laser et l'ensemble de transport sont adaptés pour que le faisceau laser incident présente une polarisation selon une direction sensiblement adaptée à la géométrie et symétrie de l'échantillon afin de maximiser localement l'intensité du champ évanescent EV dans la région R. Par exemple, lorsque l'échantillon est un nanotube ou un nanofil, une polarisation orientée selon une direction sensiblement parallèle à l'axe longitudinal du nanotube ou du nanofil permet de maximiser l'intensité du champ évanescent EV dans la région R.

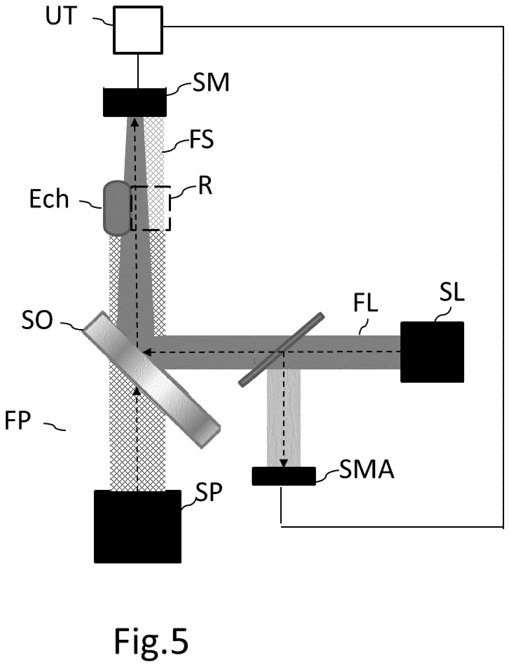

La figure 5 illustre un mode de réalisation particulier de l'invention dans lequel le système 1 comprend un spectromètre optique additionnel SMA adapté pour mesurer un spectre du faisceau laser incident simultanément à la génération du faisceau de sortie. Ainsi, le spectromètre optique additionnel SMA permet de mesurer en temps réel -ou avec une fréquence prédéterminée- la deuxième énergie $E_2(t)$ et la largeur spectrale $LS$ du faisceau FL. En outre, le processeur UT est relié au spectromètre optique additionnel SMA de sorte que la détermination la valeur du facteur d'échelle $S$ et la valeur du décalage $O$ soit effectuée à partir de la mesure de la deuxième énergie $E_2(t)$ effectuée par le spectromètre optique additionnel SMA. Ce mode de réalisation permet de réduire les imprécisions sur la valeur du facteur d'échelle $S$ et la valeur du décalage $O$ dues aux fluctuations de la valeur de la deuxième énergie en fonction du temps. Il permet de plus de déterminer plus précisément la valeur de la précision $\Delta S$ via la mesure de la largeur spectrale $LS$.

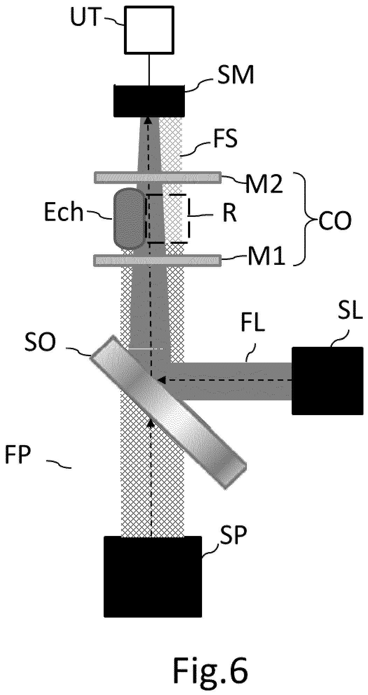

La figure 6 illustre un mode de réalisation particulier de l'invention dans lequel le système 1 comprend une cavité optique CO dans laquelle est agencé l'échantillon. Cette cavité CO est résonante pour le faisceau laser incident FL de sorte que, de par sa disposition et sa structure, la cavité optique CO soit adaptée pour que le faisceau laser incident FL effectue une pluralité de réflexions dans la cavité optique en traversant la région R en augmentant l'intensité du faisceau FL dans la région R. Cette augmentation d'intensité permet d'augmenter l'intensité du champ évanescent EV et permet donc de générer un nombre pics d'énergies distincts dans le faisceau de sortie FS plus important que le nombre de pics d'énergies distincts qui serait obtenu sans la présence de ladite cavité optique. Comme expliqué précédemment, la détection d'un nombre de pics distincts plus important dans le spectre du faisceau de sortie permet d'améliorer la précision dans la détermination du facteur d'échelle $S$ et du décalage $O$ par la sélection d'un nombre intervalles inter-pics $m$ plus important dans l'étape E.

De manière préférentielle, la cavité CO est une cavité micrométrique afin d'améliorer la compacité du système 1. De manière encore préférentielle, l'ensemble de transport SO comprend une fibre optique adaptée pour coupler le faisceau FL à la cavité CO.

La figure 7 illustre schématiquement la méthode du second mode de réalisation de l'invention. Dans ce second mode de réalisation, le processeur UT détermine que les non linéarités subies par les particules chargées lors de leur trajet et détection ne sont pas faibles ou nulles. Par exemple, le processeur détermine que les valeurs $c \times S + O$ sont inférieures ou égales à dix fois les valeurs $NL(c)$.. De plus, dans l'étape E, le processeur UT détermine la variation d'énergie $\Delta E$ d'un nombre $N > 2$ pics d'énergies distincts chacun numérotés par un indice $i \in [1; N]$ via la première l'équation. Ainsi, on obtient le deuxième système (S2) suivant :

$$(S2)\{\Delta E(c_i) = c_i \times S + O + NL(c_i) = \pm p_i \times E_2 \; ; \; i \in [1; N]$$

Avec $c_i$ le canal du détecteur matriciel où est détecté le pic d'énergie distinct d'indice $i$ et avec $p_i$ le nombre de photons absorbés/émis par les particules chargées du pic d'indice $i$.

Dans le second mode de réalisation, l'étape F consiste à résoudre le deuxième système d'équation (S2) afin de déterminer les valeurs de $NL(c_i)$, $i \in [1; N]$ et la valeur du facteur d'échelle $S$ et la valeur du décalage $O$. De plus, l'étape F comprend une deuxième sous-étape consistant à extrapoler la fonction NL à partir des N valeurs $NL(c_i)$, $i \in [1; N]$ afin de caractériser les non-linéarités subies par les particules chargées lors de leur trajet et détection. A la suite de l'étape F, et moyennant un nombre $N$ de pics d'énergies distincts détecté suffisamment élevé, la méthode de l'invention permet la caractérisation les non linéarités subies par les particules chargées lors de leur trajet au sein du système 1.

De manière préférentielle, la méthode du second mode de réalisation de l'invention comprend une étape ultérieure à l'étape F consistant à minimiser de manière itérative les valeurs de la fonction NL en répétant les étapes A à F une pluralité de fois et en modifiant des paramètres du trajet et de la détection des particules chargées entre chaque itération. Ainsi, la méthode permet de minimiser les effets-non linéaires subis par les particules chargées dans le système 1.

Par exemple, ces paramètres peuvent être l'alignement des composants optique du système 1.

Alternativement, la minimisation des valeurs de la fonction NL est effectuée à l'aide du processeur UT en mettant en œuvre les sous étapes suivantes :

A. générer un tableau de correction des valeurs d'énergies des pixels du détecteur matriciel du spectromètre SM ;
B. corriger une mesure ultérieure du spectre d'un faisceau de particules chargées par le spectromètre SM à l'aide du tableau de correction, de manière à obtenir des mesures d'énergie non ou faiblement modifiées par les effets non-linéaires.

## Revendications

1. Méthode de calibration d'un spectromètre (SM) pour particules chargées comprenant les étapes suivantes :

A. générer un faisceau de particules chargées incident (FP) monochromatique présentant une première énergie $E_1$ ;
B. générer un faisceau laser incident (FL) présentant une deuxième énergie $E_2$ ;
C. illuminer une surface (SE) d'un échantillon (Ech) avec le faisceau laser incident (FL) afin de générer un champ électromagnétique évanescent (EV) dans une région (R) à proximité de ladite surface ;
D. superposer spatialement et temporellement le faisceau laser incident et le faisceau de particules chargées incident dans ladite région afin de les coupler via ledit champ électromagnétique évanescent en générant un faisceau de particules chargées dit faisceau de sortie (FS) présentant un spectre comprenant une pluralité de pics d'énergies distincts séparés spectralement d'une valeur égale à la deuxième énergie $E_2$ ;
E. mesurer, par le spectromètre, tout ou partie du spectre du faisceau de sortie, puis déterminer une variation d'énergie $\Delta E$ d'au moins deux des pics d'énergies distincts par rapport à la première énergie $E_1$ ;
F. déterminer une valeur du facteur d'échelle $S$ et une valeur du décalage $O$ propre à ladite mesure du spectre du faisceau de sortie par le spectromètre à partir des variations d'énergie $\Delta E$.

2. Méthode selon la revendication 1, dans laquelle ladite variation d'énergie $\Delta E$ de chacun des au moins deux pics d'énergie distincts est égale à $\Delta E = \pm p \times E_2$, avec $p$ un nombre entier positif ou nul égal à un nombre d'intervalles inter-pics séparant ledit pic d'énergie distinct du pic du spectre à la première énergie $E_1$ et dans laquelle ladite variation d'énergie $\Delta E$ de chacun des au moins deux pics d'énergies distincts est déterminée dans l'étape E par le spectromètre par la relation suivante, nommée première équation :

$$\Delta E(c) = c \times S + O + NL(c)$$

avec $c$ un canal d'un détecteur matriciel du spectromètre où est détecté ledit pic d'énergie distinct, avec $NL(c)$ une fonction du canal $c$ représentative de non-linéarités subies par les particules chargées lors de leur trajet et détection, dite fonction NL.

3. Méthode selon la revendication précédente, dans laquelle on détermine que lesdites non-linéarités subies par les particules chargées sont faibles ou nulles, et, dans l'étape E, on détermine la variation d'énergie $\Delta E$ de deux des pics d'énergies distincts, numérotés par l'indice 1 et 2 respectivement via la première l'équation de manière à obtenir le premier système (S1) suivant :

$$(S1) \begin{cases} \Delta E(c_1) = c_1 \times S + O = \pm n_1 \times E_2 \\ \Delta E(c_2) = c_2 \times S + O = \pm n_2 \times E_2 \end{cases}$$

l'étape F consistant à résoudre le premier système d'équation (S1) pour déterminer la valeur du facteur d'échelle $S$ et la valeur du décalage.

4. Méthode selon la revendication précédente, dans laquelle un nombre $m > 1$ entier d'intervalles inter-pics séparant lesdits deux pics pour lesquels est déterminée la variation d'énergie $\Delta E$ est tel qu'une erreur sur la détermination de la valeur facteur d'échelle est inférieure ou égale à 1% de la deuxième énergie.

5. Méthode selon la revendication 2, dans laquelle on détermine que les non-linéarités subies par lesdites particules chargées ne sont pas faibles ou nulles et, dans l'étape E, on détermine la variation d'énergie $\Delta E$ d'un nombre $N > 2$ pics d'énergies distincts chacun numéroté par un indice $i \in [1; N]$ via la première l'équation de manière à obtenir le deuxième système (S2) suivant :

$$(S2) i \in [1; N] \{ \Delta E(c_i) = c_i \times S + O + NL(c_i) = \pm n_i \times E_2$$

l'étape F consistant à :

- résoudre le deuxième système d'équation (S2) pour déterminer la valeur du facteur d'échelle $S$ et la valeur du décalage $O$ et les N valeurs $NL(c_i)$, $i \in [1; N]$ de la fonction NL ;
- extrapoler la fonction NL à partir des N valeurs $NL(c_i)$, $i \in [1; N]$ afin de caractériser les non-linéarités subies par les particules chargées lors de leur trajet et détection.

6. Méthode selon la revendication précédente, comprenant une étape ultérieure à l'étape F consistant à minimiser de manière itérative les valeurs de la fonction NL en répétant les étapes A à F une pluralité de fois et en modifiant des paramètres du trajet et de la détection des particules chargées entre chaque itération.

7. Méthode selon l'une quelconque des revendications précédentes, dans laquelle l'étape D comprend en outre une sous étape consistant à mesurer un spectre du faisceau laser incident simultanément à la génération du faisceau de sortie, la détermination la valeur du facteur d'échelle $S$ et la valeur du décalage $O$ étant effectuée à partir de ladite mesure du spectre du faisceau laser incident.

8. Système (1) pour calibrer un spectromètre (SM) pour particules chargées, ledit système comprenant :

- une source de particules (SP) chargées adaptée pour générer un faisceau de particules chargées incident (FP) monochromatique présentant une première énergie $E_1$ ;
- une source laser (SL) adaptée pour générer un faisceau laser incident (FL) présentant une deuxième énergie $E_2$ ;
- un ensemble de transport (SO) optique et de particules chargées adapté pour :

• illuminer une surface d'un échantillon (Ech) avec le faisceau laser incident (FL) afin de générer un champ électromagnétique évanescent (EV) dans une région (R) à proximité de ladite surface ;
• superposer spatialement et temporellement le faisceau laser incident et le faisceau de particules chargées incident dans ladite région afin de les coupler via ledit champ électromagnétique évanescent de manière à générer un faisceau de particules chargées dit faisceau de sortie présentant un spectre comprenant une pluralité de pics d'énergies distincts séparés spectralement d'une valeur égale à la deuxième énergie $E_2$;

ledit spectromètre (SM) étant adapté pour mesurer tout ou partie du spectre du faisceau de sortie, ledit système comprenant en outre un processeur (UT) relié au spectromètre et adapté pour :

• déterminer une variation d'énergie $\varDelta E$ d'au moins deux des pics d'énergies distincts par rapport à la première énergie $E_1$ ;
• déterminer une valeur du facteur d'échelle $S$ et une valeur du décalage $O$ propre à ladite mesure du spectre du faisceau de sortie par le spectromètre à partir des variations d'énergie $\varDelta E$.

**9.** Système selon la revendication précédente, dans lequel le faisceau laser incident est un faisceau continu ou un faisceau impulsionnel avec une largeur spectrale inférieure à 40 meV.

**10.** Système selon les revendications 8 ou 9, comprenant un spectromètre additionnel (SMA) optique adapté pour mesurer un spectre du faisceau laser incident simultanément à la génération du faisceau de sortie, le processeur (UT) étant également relié au spectromètre additionnel (SMA) de sorte que la détermination la valeur du facteur d'échelle $S$ et la valeur du décalage 0 soit effectuée à partir de ladite mesure du spectre du faisceau laser incident (FL).

**11.** Système selon l'une quelconque des revendications 8 à 10, dans lequel la source laser et l'ensemble de transport sont adaptés pour que le faisceau laser incident présente intensité supérieure ou égale à $10^8$ $W/cm^2$ dans ladite région.

**12.** Système selon l'une quelconque des revendications 8 à 11, dans lequel la source laser et l'ensemble de transport sont adaptés pour que le faisceau laser incident présente une polarisation selon une direction adaptée à la géométrie et la symétrie de l'échantillon afin de maximiser localement l'intensité du champ évanescent (EV) dans ladite région (R).

**13.** Système selon l'une quelconque des revendications 8 à 12, dans lequel ledit ensemble de transport (SO) comprend une parabole hors axe adaptée pour focaliser le faisceau laser incident sur ladite surface de l'échantillon, ladite parabole présentant une ouverture traversée par le faisceau de particules chargées incident de sorte qu'il se co-propage avec le faisceau laser incident vers ladite région après que ce dernier se soit réfléchi sur ladite parabole hors axe.

**14.** Système selon l'une quelconque des revendications 8 à 13, comprenant une cavité optique (CO) résonante pour le faisceau laser incident (FL) dans laquelle est agencé l'échantillon, ledit ensemble de transport (SO) et ladite cavité optique étant en outre adaptés pour que le faisceau laser incident effectue une pluralité de réflexions dans la cavité optique en traversant ladite région.

**Patentansprüche**

**1.** Verfahren zur Kalibrierung eines Spektrometers (SM) für geladene Teilchen, umfassend die folgenden Schritte:

A. Erzeugen eines monochromatischen einfallenden Strahls geladener Teilchen (FP) mit einer ersten Energie $E_1$;
B. Erzeugen eines einfallenden Laserstrahls (FL) mit einer zweiten Energie $E_2$;
C. Bestrahlen einer Oberfläche (SE) einer Probe (Ech) mit dem einfallenden Laserstrahl (FL), um ein evaneszentes elektromagnetisches Feld (EV) in einem Bereich (R) nahe der Oberfläche zu erzeugen;
D. räumliches und zeitliches Überlagern des einfallenden Laserstrahls und des einfallenden Strahls geladener Teilchen in diesem Bereich, um diese über das evaneszente elektromagnetische Feld zu koppeln, wodurch ein als Ausgangsstrahl (FS) bezeichneter Strahl geladener Teilchen erzeugt wird, der ein Spektrum aufweist, das eine Vielzahl unterschiedlicher Energiespitzen umfasst, die spektral um einen der zweiten Energie $E_2$ entsprechenden Wert getrennt sind;
E. Messen des gesamten oder eines Teils des Spektrums des Ausgangsstrahls mit dem Spektrometer, dann Bestimmen einer Energieänderung $\varDelta E$ mindestens zweier unterschiedlicher Energiespitzen gegenüber der ersten Energie $E_1$;

F. Bestimmen eines Werts des Skalierungsfaktors S und eines spezifischen Werts des Versatzes O für die Messung des Spektrums des Ausgangsstrahls durch das Spektrometer anhand der Energieänderungen $\Delta E$.

2. Verfahren nach Anspruch 1, wobei die Energieänderung $\Delta E$ einer jeden der mindestens zwei unterschiedlichen Energiespitzen gleich $\Delta E = \pm p \times E_2$ ist, wobei p eine positive ganze Zahl oder die Zahl Null ist, die gleich einer Anzahl von Intervallen zwischen Spitzen ist, die die unterschiedlichen Energiespitzen von der Spitze des Spektrums bei der ersten Energie $E_1$ trennt, und wobei die Energieänderung $\Delta E$ einer jeden der mindestens zwei unterschiedlichen Energiespitzen in Schritt E durch das Spektrometer durch die folgende als erste Gleichung bezeichnete Beziehung bestimmt wird:

$$\Delta E(c) = c \times S + O + NL(c)$$

wobei c ein Kanal eines Matrixdetektors des Spektrometers ist, in dem die unterschieldiche Energiespitze erfasst wird, wobei NL(c) eine als NL-Funktion bezeichnete Funktion des Kanals c ist, die Nichtlinearitäten, denen geladene Teilchen auf ihrer Bahn und während ihrer Detektion unterliegen, repräsentiert.

3. Verfahren nach dem vorstehenden Anspruch, wobei bestimmt wird, dass die Nichtlinearitäten, denen die geladenen Teilchen unterliegen, schwach oder Null sind, und in Schritt E die Energieänderung $\Delta E$ der zwei unterschieldichen Energiespitzen, denen jeweils der Index 1 bzw. 2 zugewiesen ist, über die erste Gleichung derart bestimmt wird, dass das folgende erste System (S1) erhalten wird:

$$(S1)\begin{cases} \Delta E(c_1) = c_1 \times S + O = \pm n_1 \times E_2 \\ \Delta E(c_2) = c_2 \times S + O = \pm n_2 \times E_2 \end{cases}$$

wobei Schritt F darin besteht, das erste Gleichungssystem (S1) zu lösen, um den Wert des Skalierungsfaktors S und den Wert des Versatzes zu bestimmen.

4. Verfahren nach dem vorstehenden Anspruch, wobei eine ganzzahlige Anzahl m > 1 der Intervalle zwischen Spitzen, die die beiden Spitzen, für die die Energieänderung $\Delta E$ bestimmt wird, trennen, derart ist, dass ein Fehler bei der Bestimmung des Skalierungsfaktorwerts kleiner oder gleich 1 % der zweiten Energie ist.

5. Verfahren nach Anspruch 2, wobei bestimmt wird, dass die Nichtlinearitäten, denen die geladenen Teilchen unterliegen, nicht schwach oder Null sind, und in Schritt E die Energieänderung $\Delta E$ einer Anzahl N > 2 unterschiedlicher Energiespitzen, denen jeweils ein Index $i \in [1;N]$ zugewiesen ist, über die erste Gleichung derart bestimmt wird, dass das folgende zweite System (S2) erhalten wird:

$$(S2)\, i \in [1; N]\{\Delta E(c_i) = c_i \times S + O + NL(c_i) = \pm n_i \times E_2$$

wobei Schritt F aus Folgendem besteht:

- Lösen des zweiten Gleichungssystems (S2), um den Wert des Skalierungsfaktors S, den Wert des Versatzes O und die N Werte $NL(c_i)$, $i \in [1; N]$ der NL-Funktion zu bestimmen;
- Extrapolieren der NL-Funktion aus den N Werten $NL(c_i)$, $i \in [1; N]$, um die Nichtlinearitäten, denen die geladene Teilchen auf ihrer Bahn und während ihrer Detektion unterliegen, zu charakterisieren.

6. Verfahren nach dem vorstehenden Anspruch, umfassend einen auf Schritt F folgenden Schritt, der darin besteht, die Werte der NL-Funktion iterativ zu minimieren, indem die Schritte A bis F mehrmals wiederholt werden und zwischen jeder Iteration Parameter der Bahn und der Detektion der geladenen Teilchen geändert werden.

7. Verfahren nach einem der vorstehenden Ansprüche, wobei Schritt D ferner einen Teilschritt umfasst, der darin besteht, ein Spektrum des einfallenden Laserstrahls gleichzeitig mit der Erzeugung des Ausgangsstrahls zu messen, wobei das Bestimmen des Werts des Skalierungsfaktors S und des Werts des Versatzes O anhand der Messung des Spektrums des einfallenden Laserstrahls erfolgt.

8. System (1) zum Kalibrieren eines Spektrometers (SM) für geladene Teilchen, wobei das System Folgendes umfasst:

- eine Quelle für geladene Teilchen (SP), die geeignet ist, einen monochromatischen einfallenden Strahl geladener Teilchen (FP) mit einer ersten Energie $E_1$ zu erzeugen;
- eine Laserquelle (SL), die geeignet ist, einen einfallenden Laserstrahl (FL) mit einer zweiten Energie $E_2$ zu erzeugen;
- eine Einheit zum optischen Transport (SO) und für geladene Teilchen, die zu Folgendem geeignet ist:

• Bestrahlen einer Oberfläche einer Probe (Ech) mit dem einfallenden Laserstrahl (FL), um ein evaneszentes elektromagnetisches Feld (EV) in einem Bereich (R) nahe der Oberfläche zu erzeugen;
• räumliches und zeitliches Überlagern des einfallenden Laserstrahls und des einfallenden Strahls geladener Teilchen in diesem Bereich, um diese über das evaneszente elektromagnetische Feld derart zu koppeln, dass ein als Ausgangsstrahl bezeichneter Strahl geladener Teilchen erzeugt wird, der ein Spektrum aufweist, das eine Vielzahl unterschiedlicher Energiespitzen umfasst, die spektral um einen der zweiten Energie $E_2$ entsprechenden Wert getrennt sind;

wobei das Spektrometer (SM) geeignet ist, das gesamte Spektrum oder einen Teil des Spektrums des Ausgangsstrahls zu messen, wobei das System ferner einen mit dem Spektrometer verbundenen Prozessor (UT) umfasst, der zu Folgendem geeignet ist:

• Bestimmen einer Energieänderung $\Delta E$ mindestens zweier unterschiedlicher Energiespitzen gegenüber der ersten Energie $E_1$;
• Bestimmen eines Werts des Skalierungsfaktors S und eines spezifischen Werts des Versatzes O für die Messung des Spektrums des Ausgangsstrahls durch das Spektrometer anhand der Energieänderungen $\Delta E$.

9. System nach dem vorstehenden Anspruch, wobei der einfallende Laserstrahl ein kontinuierlicher Strahl oder ein gepulster Strahl mit einer spektralen Breite von weniger als 40 meV ist.

10. System nach Anspruch 8 oder 9, umfassend ein zusätzliches optisches Spektrometer (SMA), das geeignet ist, gleichzeitig mit der Erzeugung des Ausgangsstrahls ein Spektrum des einfallenden Laserstrahls zu messen, wobei der Prozessor (UT) ebenfalls mit dem zusätzlichen Spektrometer (SMA) derart verbunden ist, dass das Bestimmen des Werts des Skalierungsfaktors S und des Werts des Versatzes O anhand der Messung des Spektrums des einfallenden Laserstrahls (FL) erfolgt.

11. System nach einem der Ansprüche 8 bis 10, wobei die Laserquelle und die Transporteinheit so ausgelegt sind, dass der einfallende Laserstrahl in dem Bereich eine Intensität von mehr als oder gleich $10^8$ W/cm$^2$ aufweist.

12. System nach einem der Ansprüche 8 bis 11, wobei die Laserquelle und die Transporteinheit so ausgelegt sind, dass der einfallende Laserstrahl eine Polarisation in einer an die Geometrie und Symmetrie der Probe angepassten Richtung derart aufweist, dass die Intensität des evaneszenten Feldes (EV) in dem Bereich (R) lokal maximiert wird.

13. System nach einem der Ansprüche 8 bis 12, wobei die Transporteinheit (SO) eine außeraxiale Parabel umfasst, die derart ausgelegt ist, dass der einfallende Laserstrahl auf die Oberfläche der Probe fokussiert wird, wobei die Parabel eine Öffnung aufweist, durch die der einfallende Strahl geladener Teilchen derart hindurchtritt, dass er sich gemeinsam mit dem einfallenden Laserstrahl, nachdem dieser an der außeraxialen Parabel reflektiert wurde, in Richtung des Bereichs ausbreitet.

14. System nach einem der Ansprüche 8 bis 13, umfassend einen für den einfallenden Laserstrahl (FL) resonanten optischen Hohlraum (CO), in dem die Probe angeordnet ist, wobei die Transporteinheit (SO) und der optische Hohlraum ferner derart ausgelegt sind, dass der einfallende Laserstrahl im optischen Hohlraum beim Durchgang durch den Bereich einer Vielzahl von Reflexionen unterliegt.

**Claims**

1. A method of calibrating a spectrometer (SM) for charged particles comprising the following steps:

A. generating a monochromatic incident charged particle beam (FP) having a first energy $E_1$;
B. generating an incident laser beam (FL) having a second energy $E_2$;
C. illuminating a surface (SE) of a sample (Ech) with the incident laser beam (FL) to generate an evanescent electromagnetic field (EV) in a region (R) in the vicinity of said surface;

D. spatially and temporally superimposing the incident laser beam and the incident charged particle beam in said region in order to couple them via said evanescent electromagnetic field, generating a charged particle beam known as an output beam (FS) having a spectrum comprising a plurality of distinct energy peaks spectrally separated by a value equal to the second energy $E_2$;

E. measuring, using the spectrometer, all or part of the spectrum of the output beam, then determining a variation in energy $\Delta E$ of at least two of the distinct energy peaks with respect to the first energy $E_1$;

F. determining a value of the scale factor $S$ and a value of the offset $O$ specific to said measurement of the spectrum of the output beam by the spectrometer from the energy variations $\Delta E$.

2. The method according to claim 1, wherein said variation in energy $\Delta E$ of each of the at least two distinct energy peaks is equal to $\Delta E = \pm p \times E_2$, with p a positive or zero integer equal to a number of inter-peak intervals separating said distinct energy peak from the peak of the spectrum at the first energy $E_1$ and wherein said variation in energy $\Delta E$ of each of the at least two distinct energy peaks is determined in step E by the spectrometer by the following relation, referred to as the first equation:

$$\Delta E(c) = c \times S + O + NL(c)$$

with c a channel of a matrix detector of the spectrometer where said distinct energy peak is detected, with NL(c) a function of the channel c representative of non-linearities undergone by the charged particles during their path and detection, a so-called NL function.

3. The method according to the preceding claim, wherein it is determined that said non-linearities undergone by the charged particles are weak or zero, and, in step E, the variation in energy $\Delta E$ of two of the distinct energy peaks, numbered by the index 1 and 2 respectively via the first equation is determined so as to obtain the following first system (S1):

$$(S1)\begin{cases} \Delta E(c_1) = c_1 \times S + O = \pm n_1 \times E_2 \\ \Delta E(c_2) = c_2 \times S + O = \pm n_2 \times E_2 \end{cases}$$

step F consisting in solving the first equation system (S1) to determine the value of the scale factor $S$ and the value of the offset.

4. The method according to the preceding claim, wherein an integer $m > 1$ of inter-peak intervals separating said two peaks for which the variation in energy $\Delta E$ is determined is such that an error on the determination of the scale factor value is less than or equal to 1% of the second energy.

5. The method according to claim 2, wherein it is determined that the non-linearities undergone by said charged particles are not weak or zero and, in step E, the variation in energy $\Delta E$ of a number $N > 2$ of distinct energy peaks each numbered by an index $i \, \varepsilon \, [1; N]$ is determined via the first equation so as to obtain the following second system (S2):

$$(S2)\, i \in [1; N]\{\Delta E(c_i) = c_i \times S + O + NL(c_i) = \pm n_i \times E_2$$

step F consisting in:

- solving the second equation system (S2) to determine the value of the scale factor S and the value of the offset $O$ and the N values $NL(c_i)$, $i \in [1; N]$ of the NL function;
- extrapolating the NL function from the N values $NL(c_i)$, $i \in [1; N]$ to characterize the non-linearities undergone by the charged particles during their path and detection.

6. The method according to the preceding claim, comprising a step subsequent to step F consisting in iteratively minimizing the values of the NL function by repeating steps A to F a plurality of times and modifying parameters of the path and detection of charged particles between each iteration.

7. The method according to any one of the preceding claims, wherein step D further comprises a sub-step consisting in measuring a spectrum of the incident laser beam simultaneously with the generation of the output beam, the determination of the value of the scale factor S and the value of the offset $O$ being performed from said measurement of the spectrum of the incident laser beam.

8. A system (1) for calibrating a spectrometer (SM) for charged particles, said system comprising:

 - a charged particle source (SP) adapted to generate a monochromatic incident charged particle beam (FP) having a first energy $E_1$;
 - a laser source (SL) adapted to generate an incident laser beam (FL) having a second energy $E_2$;
 - an optical and charged particle transport assembly (SO) adapted for:

  • illuminating a surface of a sample (Ech) with the incident laser beam (FL) to generate an evanescent electromagnetic field (EV) in a region (R) in the vicinity of said surface;
  • spatially and temporally superimposing the incident laser beam and the incident charged particle beam in said region in order to couple them via said evanescent electromagnetic field so as to generate a charged particle beam known as an output beam having a spectrum comprising a plurality of distinct energy peaks spectrally separated by a value equal to the second energy $E_2$;

 said spectrometer (SM) being adapted to measure all or part of the spectrum of the output beam, said system further comprising a processor (UT) connected to the spectrometer and adapted for:

  • determining a variation in energy $\varDelta E$ of at least two of the distinct energy peaks with respect to the first energy $E_1$;
  • determining a value of the scale factor S and a value of the offset $O$ specific to said measurement of the spectrum of the output beam by the spectrometer from the energy variations $\varDelta E$.

9. The system according to the preceding claim, wherein the incident laser beam is a continuous beam or a pulsed beam with a spectral width of less than 40 meV.

10. The system according to claims 8 or 9, comprising an additional optical spectrometer (SMA) adapted to measure a spectrum of the incident laser beam simultaneously with the generation of the output beam, the processor (UT) also being connected to the additional spectrometer (SMA) so that determination of the value of the scale factor S and the value of the offset $O$ is effected from said measurement of the spectrum of the incident laser beam (FL).

11. The system according to any one of claims 8 to 10, wherein the laser source and transport assembly are adapted so that the incident laser beam has an intensity greater than or equal to $10^8$ $W/cm^2$ in said region.

12. The system according to any one of claims 8 to 11, wherein the laser source and transport assembly are adapted so that the incident laser beam is polarized in a direction adapted to the geometry and the symmetry of the sample in order to locally maximize the intensity of the evanescent field (EV) in said region (R).

13. The system according to any one of claims 8 to 12, wherein said transport assembly (SO) comprises an off-axis parabola adapted to focus the incident laser beam onto said surface of the sample, said parabola having an aperture through which the incident charged particle beam passes so that it co-propagates with the incident laser beam towards said region after the latter has reflected off said off-axis parabola.

14. The system according to any one of claims 8 to 13, comprising a resonant optical cavity (CO) for the incident laser beam (FL) wherein the sample is arranged, said transport assembly (SO) and said optical cavity being further adapted so that the incident laser beam makes a plurality of reflections in the optical cavity as it passes through said region.

Fig.1A

Fig.1B

Fig.1C

Fig.1D

A | Générer le faisceau de particules chargées incident FP avec énergie

B | Générer le faisceau laser incident FL avec énergie

C | Illuminer l'échantillon avec le faisceau FL afin de créer un champ électromagnétique évanescent EV dans une région R

D | Superposer spatio-temporellement les faisceaux FL et FP dans la région R afin de générer un faisceau de sortie FS avec un spectre comprenant des pics d'énergie distincts séparés spectralement p

E | Mesurer le spectre du faisceau FS par un spectromètre et déterminer une variation d'énergie de pics d'énergies distincts par rapport à la première énergie

F | Déterminer le facteur d'échelle et le décalage propre au spectromètre

## Fig.2

Fig.3

Fig.4A

Fig.4B

Fig.4C

Fig.5

UT

SM

FS

Ech

M2

R

CO

M1

SL

FL

SO

FP

SP

Fig.6

A — Générer le faisceau de particules chargées incident FP avec énergie

(⋮)

E —
- déterminer une variation d'énergie de $N > 2$ pics d'énergies distincts
- obtenir le système d'équation (S2)

$$(S2)\ \{\Delta E(c_i) = c_i \times S + O + NL(c_i) = \pm\, p_i \times E_2\ ; \quad i \in [1; N]$$

F —
- résoudre (S2) pour déterminer $S$ et $O$ et les N valeurs $NL(c_i)$
- extrapoler la fonction NL à partir des $NL(c_i)$

## Fig.7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **SAPOZHNIK et al.** Integrated Nanophotonic Electron Beam Modulators Enable Ultra-High Precise Method for Calibrating EELS Spectrometers. *microscopy and microanalysis*, 2022, vol. 28, 792-793

- **BARWICK, B.** ; **FLANNIGAN, D. J** ; **ZEWAIL, A. H.** Photon-induced near-field electron microscopy. *Nature*, 2009, vol. 462 (7275), 902-906